# FASCICULE DE BREVET EUROPEEN

(11) **EP 3 826 061 B1**
(45) Date de publication et mention de la délivrance du brevet: **17.04.2024**
(21) Numéro de dépôt: 20209369.6
(22) Date de dépôt: 24.11.2020
(51) Int. Cl.: H01L 27/12, H01L 21/84, H01L 21/762

(54) **DISPOSITIF ÉLECTRONIQUE HYBRIDE ET PROCÉDÉ DE FABRICATION D'UN TEL DISPOSITIF**
HYBRIDE ELEKTRONISCHE VORRICHTUNG UND VERFAHREN ZUR HERSTELLUNG EINER SOLCHEN VORRICHTUNG
HYBRID ELECTRONIC DEVICE AND METHOD FOR MANUFACTURING SUCH A DEVICE

(30) Priorité: 25.11.2019 FR 1913152
(43) Date de publication de la demande: 26.05.2021
(73) Titulaire: Commissariat à l'Energie Atomique et aux Energies Alternatives, 75015 Paris (FR)
(72) Inventeur: COLINGE, Jean-Pierre, 38054 Grenoble Cedex 9 (FR)
(74) Mandataire: Cabinet Camus Lebkiri

(56) Documents cités:
- EP-A1- 3 107 119
- EP-A1- 3 531 444
- JP-A- 2012 174 884
- US-A1- 2018 358 381
- US-B1- 9 899 415

## Description

### DOMAINE TECHNIQUE

La présente invention est relative aux dispositifs ou composants électroniques formés à partir d'une structure multicouche comprenant une couche de support, une couche active en matériau semi-conducteur et une couche électriquement isolante disposée entre la couche de support et la couche active.

### ÉTAT DE LA TECHNIQUE

Différents types de substrat peuvent être utilisés pour fabriquer des composants électroniques. Le substrat est généralement choisi en fonction du type de composant à fabriquer : circuits radiofréquences (RF), circuits logiques à base de transistors MOS, capteurs d'images...

Parmi les substrats d'intérêt, on peut citer la structure multicouche silicium sur isolant ou SOI (pour « Silicon On Insulator » en anglais). La structure multicouche SOI comprend successivement une couche de support en silicium, une couche électriquement isolante, généralement une couche d'oxyde dite enterrée (ou couche BOX, pour « buried oxide layer » en anglais), et un film mince en silicium monocristallin, aussi appelé couche active. La couche active est ainsi nommée car elle est destinée à recevoir des composants actifs, typiquement des transistors MOS (acronyme de « Metal Oxide Semiconductor »). Le canal de conduction des transistors MOS est formé dans la couche active.

La structure SOI offre la possibilité de fabriquer des transistors complètement déplétés ou FDSOI (« Fully Depleted SOI »). Pour qu'un transistor MOS puisse fonctionner en mode complètement déplété, l'épaisseur du film de silicium doit être suffisamment faible pour que la zone de déplétion du transistor atteigne la couche d'oxyde enterrée. Le principal avantage de technologie FDSOI est l'amélioration du contrôle électrostatique du canal par la grille du transistor, minimisant ainsi les effets de canaux courts.

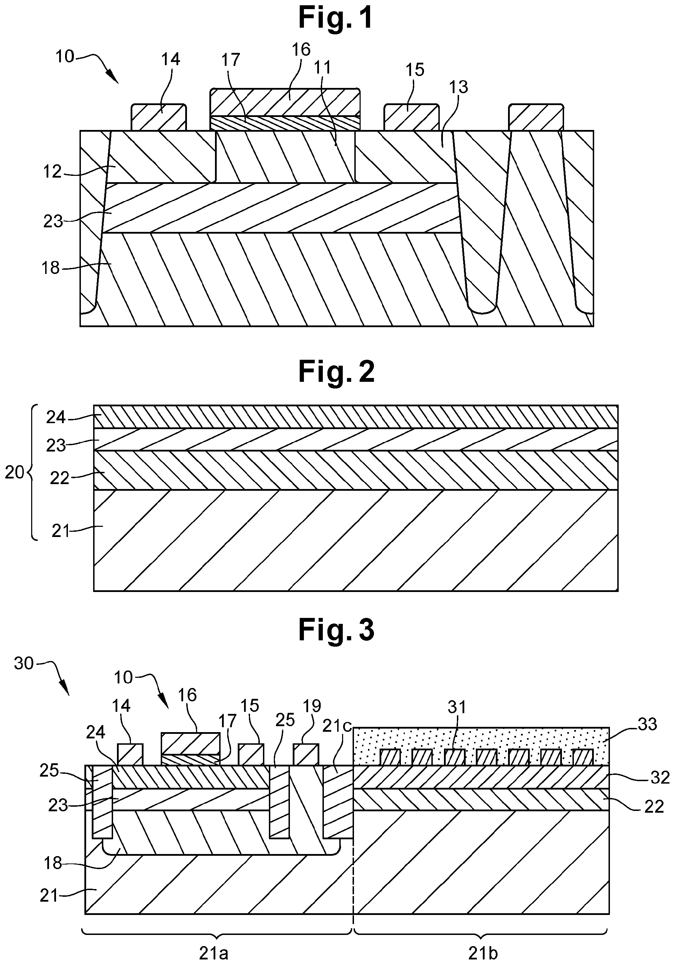

[Fig. 1] : La figure 1 montre un transistor FDSOI 10 fabriqué à partir d'une structure SOI dont la particularité est que la couche d'oxyde enterrée 23 est extrêmement mince, typiquement d'épaisseur inférieure à 30 nm. Ce type de transistor FDSOI est appelé « à corps et oxyde enterré ultraminces » ou UTBB (pour « Ultra Thin Body and BOX » en anglais).

Le transistor UTBB FDSOI 10 comprend de façon classique un canal de conduction 11, une région de drain 12 et une région de source 13, tous les trois formés dans le film mince de silicium de la structure SOI. La région de drain 12 et la région de source 13 sont séparées par le canal de conduction 11. Le film mince de silicium est surmonté d'une électrode de drain 14 (en contact avec la région de drain 11), d'une électrode de source 15 (en contact avec la région de source 12) et d'une électrode de grille 16, cette dernière étant séparée de la portion de silicium où se forme le canal de conduction 11 par un oxyde de grille 17. Le transistor 10 comprend en outre une couche de silicium dopé 18 appelée caisson (« well »), plan de masse (« ground plane ») ou encore grille arrière (« back gate »), dont une partie est située sous la couche d'oxyde enterrée 23. Le transistor 10 repose sur la couche de support en silicium (non représentée) de la structure SOI.

En faisant varier la tension de polarisation du caisson 18, séparé du canal de conduction 11 par la couche d'oxyde enterrée 23 ultramince, il est possible de moduler la tension de seuil du transistor UTBB FDSOI. Le caisson 18 agit ainsi comme une seconde grille et permet de modifier facilement le rapport consommation électrique/performances du transistor en fonction des besoins.

[Fig. 2] : La figure 2 montre une autre structure multicouche 20, dérivée de la structure SOI et couramment utilisée pour la fabrication de circuits radiofréquences (RF), tels que les modules d'émission-réception de signaux radiofréquences intégrés dans les téléphones portables (modules dits « front-end »).

Cette structure multicouche 20, appelée « TR-SOI », comprend successivement une couche de support 21 en silicium de haute résistivité, une couche riche en pièges (« trap-rich layer ») 22, une couche d'oxyde enterrée 23 et une couche active 24 en silicium monocristallin. La couche riche en pièges 22 empêche le phénomène de conduction parasite à l'interface entre la couche de support 21 et la couche d'oxyde enterrée 23, ce phénomène étant habituellement causé par des électrons libres qui s'accumulent à l'interface sous l'effet des charges positives fixes contenues dans la couche d'oxyde enterrée 23. Grâce à la couche riche en pièges 22, les électrons sont piégés et ne peuvent plus circuler. La résistivité effective de la couche de support 21 est ainsi augmentée par rapport à une structure multicouche dépourvue de couche riche en pièges (structure appelée « HR-SOI »). La couche riche en pièges 22 peut être constituée de silicium polycristallin. Les pièges sont situés aux joins de grain du silicium polycristallin.

La structure TR-SOI 20 améliore grandement les performances RF des circuits intégrés fabriqués à partir de cette structure, notamment en termes de linéarité et de diaphonie. Les éléments passifs (inductances, capacités...) formés au-dessus de la couche active 24 bénéficient quant à eux d'un meilleur facteur de qualité.

Pour optimiser les performances des téléphones portables intelligents et autres objets connectés, il est aujourd'hui nécessaire de fabriquer séparément des circuits intégrés logiques en technologie CMOS (ex. processeur) à partir de la structure SOI (Fig.1) et des circuits intégrés RF (ex. modules d'émission-réception) à partir de la structure TR-SOI (Fig.2), puis de rassembler ces différents circuits intégrés sur une même carte mère. II en résulte un encombrement important, au détriment d'autres fonctions, telles que le stockage d'énergie.

Par ailleurs, le document EP3107119A1 décrit un dispositif électronique co-intégrant un circuit RF dans une première région d'un substrat semiconducteur de haute résistivité et un circuit analogique ou numérique dans une deuxième région du substrat, distincte de la première région. La première région du substrat est munie d'une couche riche en pièges. La couche riche en pièges est formée par implantation ionique d'impuretés dans le substrat à travers une couche diélectrique et une couche semi-conductrice préalablement formées sur le substrat.

Enfin, le document EP3531444A1 décrit un circuit intégré comprenant un substrat de type FDSOI, des composants non-radiofréquences (par exemple des transistors) dans une première région du substrat, une région riche en pièges localisée uniquement dans une deuxième région du substrat (distincte de la première région) et des composants RF passifs (tels que des inductances) disposés au-dessus de la région riche en pièges.

Le procédé de fabrication de ce circuit intégré comprend :
- la fourniture d'un substrat SOI comprenant successivement un substrat porteur, une couche isolante enterrée (« BOX ») et un film-semiconducteur ;
- la gravure du film-semiconducteur et du BOX dans la deuxième région, de manière à former une tranchée s'étendant jusqu'au substrat porteur ;
- le dépôt d'une couche de matériau semi-conducteurs polycristallin dans la tranchée pour former la région riche en pièges ;
- la planarisation de la couche de matériau semi-conducteurs polycristallin par polissage mécano-chimique ; et
- la formation des composants non-radiofréquences dans la première région et des composants RF passifs dans la deuxième région.

### RÉSUMÉ DE L'INVENTION

L'invention a pour but de réduire l'encombrement de ces systèmes dits « hétérogènes » qui sont composés de circuits intégrés appartenant à des technologies différentes.

On tend vers cet objectif en prévoyant un dispositif électronique comprenant :
- un substrat en un matériau semi-conducteur de haute résistivité ;
- une couche active disposée sur une première région du substrat ;
- une couche électriquement isolante disposée sur la première région du substrat, entre le substrat et la couche active ;
- au moins un transistor MOS à grille arrière formé en partie dans la couche active ;
- une couche de confinement des électrons disposée sur une deuxième région du substrat, distincte de la première région ;
- au moins un composant passif, tel qu'une inductance, disposé sur la couche de confinement des électrons.

On appelle ci-dessus « transistor MOS à grille arrière » un transistor MOS comprenant un canal de conduction, une couche électriquement conductrice séparée du canal de conduction par la couche électriquement isolante, par exemple une couche d'oxyde enterrée (BOX).

La couche de confinement des électrons désigne une couche dans laquelle le mouvement des électrons est inhibé. La couche de confinement des électrons peut être une couche riche en pièges comprenant un matériau semi-conducteur polycristallin ou une couche de matériau semi-conducteur poreux.

Le dispositif électronique selon le premier aspect de l'invention est un composant électronique hybride puisqu'il intègre, sur un même substrat, un ou plusieurs transistors MOS à grille arrière appartenant à un circuit logique, et un ou plusieurs composants passifs appartenant à un circuit radiofréquence (RF). Il remplace donc avantageusement deux composants distincts et constitue une alternative moins encombrante (et moins onéreuse) à l'assemblage de différentes puces ou circuits intégrés.

Cette co-intégration logique CMOS/RF est rendue possible par le formation *in-situ* d'une couche de confinement des électrons, sur une partie seulement d'un substrat en matériau semi-conducteur de haute résistivité. La fabrication d'un transistor à grille arrière est en effet incompatible avec l'utilisation d'une telle couche de confinement. Dans le cas d'une couche riche en pièges, les électrons piégés « épinglent » le champ électrique produit par la grille arrière, empêchant toute modulation de la tension de seuil du transistor.

De préférence, la couche de confinement des électrons est en contact avec la deuxième région du substrat.

Avantageusement, le dispositif électronique comprend en outre une couche diélectrique disposée entre ledit au moins un composant passif et la couche de confinement des électrons.

Dans un mode de réalisation du dispositif électronique, la couche de confinement des électrons comprend un matériau semi-conducteur polycristallin, par exemple du silicium polycristallin ou un alliage silicium-germanium polycristallin.

Selon un développement de ce mode de réalisation, la couche de confinement des électrons comprend en outre un oxyde de germanium (GeOₓ), un oxyde de silicium (SiOₓ) ou un nitrure de silicium (SiₓN_{y}).

Dans une variante de réalisation du dispositif électronique, la couche de confinement des électrons comprend un matériau semi-conducteur poreux, par exemple du silicium poreux ou un alliage silicium-germanium poreux.

Le dispositif électronique peut également comprendre un transistor radiofréquence formé en partie dans la couche active et couplé audit au moins un élément passif.

L'invention concerne un procédé de fabrication d'un dispositif électronique, ce procédé de fabrication comprenant les étapes suivantes :
- fournir une structure multicouche comprenant un substrat en un matériau semi-conducteur de haute résistivité, une couche active et une couche électriquement isolante disposée entre le substrat et la couche active ;
- former dans une première région de la structure multicouche au moins un transistor MOS à grille arrière ;
- graver la couche active et la couche électriquement isolante dans une deuxième région de la structure multicouche, distincte de la première région ;
- former une couche de confinement des électrons sur le substrat dans la deuxième région de la structure multicouche ; et
- former au moins un composant passif, tel qu'une inductance, sur la couche de confinement des électrons. Selon l'invention, ledit au moins un transistor MOS à grille arrière est formé dans la première région avant l'étape de gravure de la couche active et de la couche électriquement isolante. De plus la couche de confinement des électrons est formée dans la deuxième région après l'étape de gravure de la couche active et de la couche électriquement isolante.

De préférence, le procédé de fabrication comprend en outre une étape de dépôt d'une couche diélectrique sur la couche de confinement des électrons avant l'étape de formation dudit au moins un composant passif.

Selon un premier mode de mise en oeuvre, la formation de la couche de confinement des électrons comprend les opérations suivantes :
- déposer une couche de matériau semi-conducteur amorphe ;
- recristalliser le matériau semi-conducteur amorphe de façon à obtenir une couche de matériau semi-conducteur polycristallin.

Avantageusement, la formation de la couche de confinement des électrons comprend en outre, avant l'opération de recristallisation, une opération consistant à introduire des impuretés dans le matériau semi-conducteur amorphe.

Selon un deuxième mode de mise en oeuvre, la formation de la couche de confinement des électrons comprend le dépôt d'une couche de matériau semi-conducteur polycristallin.

Selon un développement de ces modes de mise en oeuvre, la formation de la couche de confinement des électrons comprend en outre une opération d'oxydation de la couche de matériau semi-conducteur polycristallin.

Le procédé de fabrication selon le deuxième aspect de l'invention peut également présenter une ou plusieurs des caractéristiques ci-dessous, considérées individuellement ou selon toutes les combinaisons techniquement possibles :
- la couche active et la couche électriquement isolante sont gravées dans la deuxième région au travers d'un masque, de préférence un masque dur ;
- le masque recouvre ledit au moins un transistor MOS à grille arrière dans la première région ; et
- le masque est retiré après l'étape de formation dudit au moins un composant passif.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1 représente schématiquement une première structure multicouche selon l'art antérieur, utilisée comme substrat de départ pour la fabrication de circuits intégrés logiques ;
- la figure 2 représente schématiquement une deuxième structure multicouche selon l'art antérieur, utilisée comme substrat de départ pour la fabrication de circuits intégrés radiofréquences ;
- la figure 3 représente un mode de réalisation préférentiel d'un dispositif électronique selon le premier aspect de l'invention ; et
- les figures 4A à 4G représentent les étapes d'un procédé de fabrication de dispositif électronique selon le deuxième aspect de l'invention.

Pour plus de clarté, les éléments identiques ou similaires sont repérés par des signes de référence identiques sur l'ensemble des figures.

### DESCRIPTION DÉTAILLÉE

[Fig. 3] : La figure 3 est une vue schématique en coupe d'un dispositif (ou composant) électronique hybride 30 selon un mode de réalisation préférentiel de l'invention.

Le dispositif électronique hybride 30 comprend un substrat 21 en matériau semi-conducteur de haute résistivité, par exemple en silicium. Un matériau semi-conducteur est ici qualifié de haute résistivité lorsque sa résistivité électrique est supérieure ou égale à 1000 Ω.cm. Une telle résistivité permet de réduire la transmission de signaux électromagnétiques parasites, via le substrat, entre les différents composants (actifs ou passifs) formés sur le substrat et les courants de Foucault dans le substrat, limitant ainsi les pertes par effet Joule qui en découlent.

Le substrat 21 (aussi appelé couche de support) comprend une première région 21a et une deuxième région 21b, distincte de la première région 21a (c.-à-d. les première et deuxième régions 21a-21b ne se chevauchent pas). La première région 21a supporte au moins un transistor MOS à grille arrière 10, tandis que la deuxième région 21b supporte au moins un composant passif 31. Les première et deuxième régions 21a-21b peuvent être juxtaposées, comme cela est illustré sur la figure 3, ou être espacées latéralement l'une de l'autre.

Le transistor MOS à grille arrière 10 est formé en partie dans une couche active 24 disposée sur la première région 21a du substrat et séparée du substrat 21 par une couche électriquement isolante 23. La couche active 24 est de préférence un film mince de matériau semi-conducteur, intrinsèque ou dopé, par exemple en silicium monocristallin, en germanium, en alliage de silicium-germanium ou en un matériau semi-conducteur III-V. La couche électriquement isolante 23 peut être une couche d'oxyde dite enterrée (car enfouie sous la couche active 24), par exemple en dioxyde de silicium (SiO₂), ou une couche de tout autre matériau diélectrique, par exemple en nitrure de silicium. Une particularité du dispositif électronique hybride 30 est que la couche électriquement isolante 23 et la couche active 24 ne s'étendent pas en dehors de la première région 21a du substrat 21. Autrement dit, ces couches caractérisent la première région 21a du substrat 21 et sont donc spatialement limitées à la première région 21a.

Le transistor MOS 10 comprend un canal de conduction, une région de drain et une région de source, tous les trois formés dans la couche active 24. Le canal de conduction sépare la région de drain et la région de source. Le canal de conduction, la région de drain et la région de source forment ensemble la zone active du transistor, qui peut être délimitée par des tranchées d'isolation peu profondes 25. La couche active 24 est surmontée d'une électrode de drain 14 (en contact avec la région de drain), d'une électrode de source 15 (en contact avec la région de source) et d'une électrode de grille 16. L'électrode de grille 16 est séparée de la couche active 24 où se forme le canal de conduction par un diélectrique de grille 17, typiquement un oxyde.

Le transistor MOS 10 comprend en outre une grille arrière 18, aussi appelée caisson ou plan de masse. La grille arrière 18 est une couche électriquement conductrice qui s'étend au moins en partie sous la couche électriquement isolante 23 (et le canal de conduction du transistor 10) et qui permet de modifier la tension de seuil du transistor. La grille arrière 18 peut être polarisée à une tension positive ou négative, par exemple grâce à un contact de grille arrière 19 situé au même niveau que les électrodes de drain et de source 14-15. L'épaisseur de la couche électriquement isolante 23 est de préférence inférieure à 30 nm, afin d'optimiser le contrôle électrostatique du canal de conduction par la grille arrière 18.

Le transistor MOS à grille arrière 10 est de préférence de type FDSOI, c'est-à-dire un transistor fonctionnant en mode complètement déplété et fabriqué à partir d'une structure multicouche SOI (silicium sur isolant) comprenant un substrat 21 en silicium de haute résistivité (HR-SOI). L'épaisseur de la couche active 24 est de préférence comprise entre 4 nm et 24 nm, par exemple égale à 8 nm.

Le composant passif 31 est par exemple une ligne de transmission (de signaux RF), une capacité, un filtre ou une inductance. Le composant passif 31 est disposé sur une couche de confinement des électrons 22, elle-même disposée sur la deuxième région 21b du substrat 21. La couche de confinement des électrons 22 est de préférence en contact direct avec le substrat 21.

Dans le mode de réalisation préférentiel de la figure 3, le composant passif 31 repose sur une première couche diélectrique 32, par exemple en dioxyde de silicium (SiO₂), disposée sur la couche de confinement 22. La première couche diélectrique 32 améliore l'isolation électrique du composant passif 31, en supprimant les courants de fuite à travers la couche de confinement 22.

Le composant passif 31 peut être également recouvert ou enrobé par une deuxième couche diélectrique 33, dont le matériau peut être différent de celui de la première couche diélectrique 32.

La couche de confinement des électrons 22 se situe ainsi entre le substrat 21 et la première couche diélectrique 32. Elle limite fortement la circulation des électrons libres qui s'accumulent sous la première couche diélectrique 32, sous l'effet des charges positives fixes contenues dans la première couche diélectrique 32 et/ou d'une polarisation (positive) du composant passif 31. L'épaisseur de la couche de confinement 22 est de préférence comprise entre 10 nm et 2 µm.

La couche de confinement 22 peut être une couche riche en pièges. Pour former une couche riche en pièges, la couche de confinement 22 peut comporter un matériau semi-conducteur polycristallin, tel que du silicium polycristallin ou un alliage silicium-germanium polycristallin. Les pièges d'électrons sont alors situés aux joins de grain du matériau semi-conducteur polycristallin, c'est-à-dire entre les différents cristaux de matériau semi-conducteur. Afin d'augmenter la densité de pièges, la couche de confinement 22 peut comporter en outre un oxyde de germanium (GeOₓ), un oxyde de silicium (SiOₓ) ou un nitrure de silicium (SiₓN_{y}), par exemple sous la forme de microcristaux ou de particules. Ces microcristaux ou particules se concentrent aux joins de grain du matériau semi-conducteur polycristallin.

Alternativement, la couche de confinement 22 peut être une couche de matériau semi-conducteur poreux, par exemple du silicium poreux ou du silicium-germanium poreux. La dimension maximale des pores est avantageusement inférieure à 200 nm.

La couche de confinement 22, la couche diélectrique 32 et le composant passif 31 ne s'étendent pas en dehors de la deuxième région 21b du substrat 21. La couche de confinement 22 et la couche diélectrique 32 sont avantageusement séparées (latéralement) de la couche électriquement isolante 23 et de la couche active 24 (situées dans la première région 21a) par un motif d'isolation 21c, de préférence formé en même temps que les tranchées d'isolation 25.

Sur la figure 3, un seul transistor MOS à grille arrière 10 et un seul composant passif 31 ont été représentés.

Néanmoins, la première région 21a du substrat 21 peut supporter plusieurs transistors MOS à grille arrière 10, du même type que celui décrit ci-dessus, et la deuxième région 21b du substrat 21 peut supporter plusieurs composants passifs 31 d'un même type ou de types différents.

Les transistors MOS à grille arrière 10 appartiennent de préférence à un circuit (intégré) logique, par exemple un microprocesseur. Un circuit logique désigne un circuit capable de remplir une ou plusieurs fonctions logiques, par exemple des calculs.

Le dispositif électronique hybride 30 peut comporter à la fois des transistors MOS à grille arrière 10 de type n (c.-à-d. région de drain et de source dopées de type n) et des transistors MOS à grille arrière 10 de type p (c.-à-d. région de drain et de source dopées de type p). Le caisson 18 des transistors n-MOS et le caisson 18 des transistors p-MOS sont respectivement dopés de type p et de type n. Le circuit logique est alors fabriqué en technologie CMOS (acronyme de « Complementary Metal Oxide Semiconductor »).

Les composants passifs 31 appartiennent de préférence à un circuit (intégré) radiofréquence, par exemple un module d'émission-réception « front-end ». Ils ont pour but de générer ou traiter (ex. filtrer, amplifier...) des signaux radiofréquences. Un circuit radiofréquence désigne un circuit capable de remplir une ou plusieurs fonctions de communication (ex : technologies sans-fil Wi-Fi, bluetooth, LTE...).

La deuxième région 21b étant dépourvue de couche active semiconductrice, elle ne peut pas accueillir de transistors. Cependant, la première région 21a peut comporter, outre le transistor MOS 10, un ou plusieurs transistors conçus pour recevoir des signaux radiofréquences (transistors dits « radiofréquences »). Ces transistors radiofréquences sont formés dans la couche active 24 et couplés à l'élément (ou aux éléments) passif(s) 31 de la deuxième région 21b. Comme les transistors sont généralement peu nombreux dans un circuit radiofréquence et occupe chacun une surface faible comparés aux éléments passifs, en particulier les inductances, ils n'ont pas besoin d'être formés au-dessus de la couche de confinement 22.

La première région 21a du substrat 21 est ainsi dédiée aux composants actifs du dispositif électronique hybride 30, tandis que la deuxième région 21b adjacente du substrat 21 est réservée aux composants passifs du dispositif électronique hybride 30.

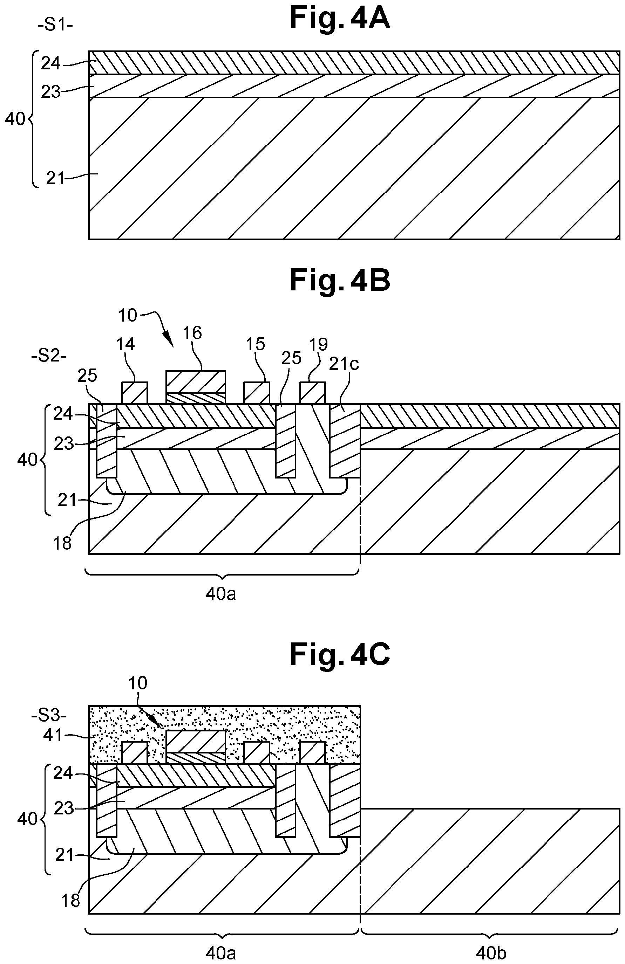

Les figures 4A à 4G illustrent des étapes S1 à S7 d'un procédé de fabrication du dispositif électronique hybride 30 selon la figure 3.

[Fig. 4A] : La première étape S1 du procédé de fabrication consiste à prévoir une unique structure multicouche 40 sur laquelle les deux régions 21, 21b vont être fabriquées séquentiellement. La structure multicouche 40 comprend successivement un substrat 21 en matériau semi-conducteur de haute résistivité, une couche électriquement isolante 23 et une couche active 24. La structure multicouche 40 est de préférence une structure multicouche SOI (silicium sur isolant) comprenant un substrat 21 en silicium de haute résistivité (HR-SOI).

[Fig. 4B] : En référence à la figure 4B, le procédé de fabrication comprend ensuite une étape S2 de formation d'au moins un transistor MOS à grille arrière 10 dans une première région 40a de la structure multicouche 40.

La formation du transistor MOS 10 comprend notamment la formation d'un caisson ou grille arrière 18 dans la structure multicouche 40, la formation de tranchées d'isolation peu profondes 25 dans la structure multicouche 40 (afin de délimiter la zone active du transistor dans la couche active 24), la formation d'une structure de grille sur la couche active 24 (la structure de grille comprenant une électrode de grille 16 et un diélectrique de grille 17), le dopage de la couche active pour former des régions de drain et de source (non représentées sur les figures), la formation d'une électrode (ou contact) de drain 14, d'une électrode (ou contact) de source 15 et d'un contact de grille arrière 19 sur la couche active 24. La formation du transistor MOS 10 peut également comprendre une étape d'épitaxie sur les régions de drain et de source pour diminuer la résistance des contacts de source et de drain.

La grille arrière 18 est de préférence formée en implantant des dopants (de type n ou p, selon le type de transistor MOS à fabriquer) dans une partie du substrat 21 en matériau semi-conducteur de haute résistivité.

Les tranchées d'isolation 25 sont de préférence formées en gravant des tranchées dans la structure multicouche, jusqu'au substrat 21, puis en les remplissant d'un matériau diélectrique (technique d'isolation dite STI, pour « Shallow Trench Isolation » en anglais). Un motif d'isolation additionnel 21c est avantageusement formé en même temps que les tranchées d'isolation 25 pour isoler électriquement la grille arrière 18 de la partie restante de la couche active 24.

Les étapes de fabrication d'un transistor MOS à grille arrière (ou double grille) étant connues, elles ne seront pas décrites plus en détail ici.

[Fig. 4C] : A l'étape S3 de la figure 4C, la première région 40a de la structure multicouche 40 est recouverte d'un masque 41, puis la couche active 24 et la couche électriquement isolante 23 sont gravées successivement à travers le masque 41 dans une deuxième région 40b de la structure multicouche 40. Le masque 41 est de préférence un masque dur, par exemple en nitrure de silicium (Si₃N₄). Il protège le transistor MOS 10 de la gravure et des étapes ultérieures de fabrication du dispositif électronique hybride 30.

A titre d'exemple, une couche active 24 en silicium peut être gravée par voie humide, par exemple dans une solution d'hydroxyde de tétra-méthyle ammonium (TMAH), tandis qu'une couche électriquement isolante 23 en dioxyde de silicium peut être gravée dans une solution d'acide fluorhydrique (HF).

Le procédé de fabrication comprend ensuite une étape de formation d'une couche de confinement des électrons dans la deuxième région 40b, où le substrat 21 a été découvert. Une partie de la couche active 24 et une partie de la couche électriquement isolante 23 ont donc été « sacrifiées » pour pouvoir former localement la couche de confinement des électrons.

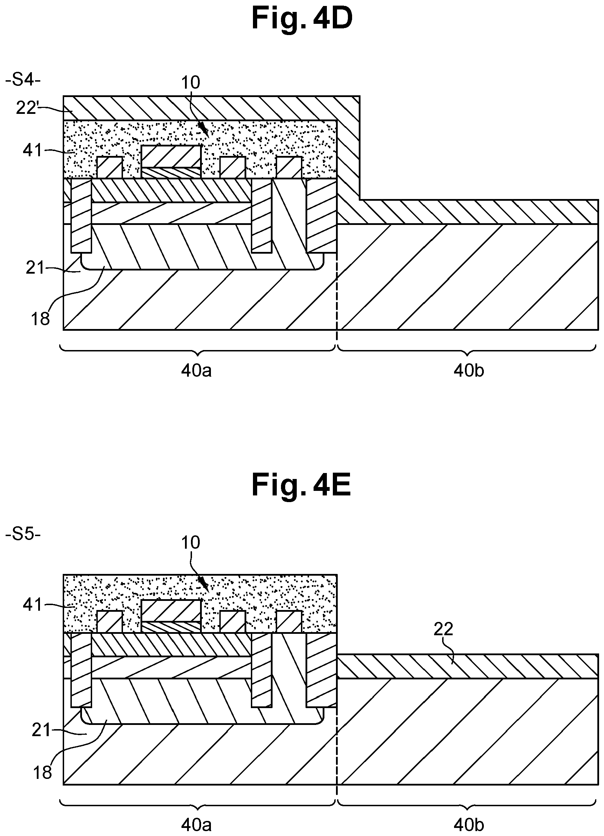

[Fig. 4D] : Dans un premier mode de mise en oeuvre représenté par la figure 4D, la formation de la couche de confinement comprend le dépôt d'une couche de matériau semi-conducteur polycristallin 22', par exemple par dépôt chimique en phase vapeur à basse pression (ou LPCVD, pour « Low Pressure Chemical Vapor Déposition » en anglais). Le dépôt est conforme et s'effectue sur toute la surface du substrat 21 (dépôt dit « pleine plaque »). La couche de matériau semi-conducteur polycristallin 22' recouvre alors le masque dur 41 dans la première région 40a et le substrat 21 dans la deuxième région 40b. Le matériau semi-conducteur polycristallin est de préférence du silicium ou un alliage silicium-germanium (GeₓSi₁₋ₓ).

Les conditions de dépôt sont avantageusement choisies pour que les cristaux du matériau semi-conducteur polycristallin aient des dimensions inférieures à 100 nm. Ces cristaux de petite taille permettent d'obtenir une densité de pièges élevée.

Le dépôt LPCVD s'effectue par exemple dans les conditions suivantes : dépôt par pyrolyse de silane, disilane ou trisilane, à une température comprise entre 600 °C et 630 °C.

[Fig. 4E] : Lors d'une étape S5 représentée par la figure 4E, la portion de la couche de matériau semi-conducteur polycristallin 22' disposée sur la première région 40a et le masque 41 est gravée, par exemple au moyen d'une étape de photolithographie et d'une étape de gravure chimique au TMAH.

La couche de matériau semi-conducteur polycristallin 22' est ainsi limitée à la deuxième région 40b et forme la couche de confinement des électrons 22.

Dans un deuxième mode de mise en oeuvre non représenté par les figures, la formation de la couche de confinement 22 comprend une première opération consistant à déposer d'une couche de matériau semi-conducteur amorphe et une deuxième opération consistant à recristalliser le matériau semi-conducteur amorphe, afin de transformer la couche de matériau semi-conducteur amorphe en une couche de matériau semi-conducteur polycristallin. Des impuretés telles que des ions/atomes de carbone (C), azote (N) ou germanium (Ge) peuvent être introduites dans le matériau semi-conducteur amorphe, par exemple par implantation ionique, de façon à augmenter la densité de pièges aux joints de grains lors de la recristallisation et/ou réduire la taille des grains recristallisés.

Le dépôt de matériau semi-conducteur amorphe est de préférence effectué par LPCVD, par exemple dans les conditions suivantes : dépôt par pyrolyse de silane, disilane ou trisilane, à une température comprise entre 500 °C et 600 °C.

Le matériau semi-conducteur amorphe peut être recristallisé en le soumettant à un recuit sous une atmosphère neutre ou oxydante, par exemple à une température comprise entre 600 °C et 650°C pendant une durée comprise entre 5 minutes et 60 minutes, par une étape de recuit rapide (« Rapid Thermal Annealing » en anglais) pour une durée de quelques secondes ou par impulsions laser d'une durée de l'ordre de la milliseconde.

La gravure du matériau semi-conducteur en excès (c'est-à-dire la portion recouvrant le masque 41) peut être accomplie avant ou après l'opération de recristallisation.

La formation de la couche de confinement 22 peut comprendre en outre une opération d'oxydation de la couche de matériau semi-conducteur polycristallin, par exemple par traitement thermique sous une atmosphère contenant de l'oxygène, afin de former un oxyde de germanium GeOₓ (en présence de germanium) ou un oxyde de silicium (SiOₓ) qui sont riches en pièges.

La couche de confinement 22 peut être également formée en rendant poreuse une portion superficielle du substrat 21 ou une couche de matériau semi-conducteur (ex. Si, SiGe) déposée préalablement sur le substrat 21 dans la deuxième région 40b. La portion superficielle du substrat ou la couche de matériau semi-conducteur est dopée de type p ou fortement dopée de type n (concentration en impuretés dopantes de type n supérieure à 10¹⁸ cm⁻³). Le matériau semi-conducteur est rendu poreux par dissolution anodique, en plongeant le substrat dans un électrolyte à base d'acide fluorhydrique (HF) puis en appliquant un champ électrique.

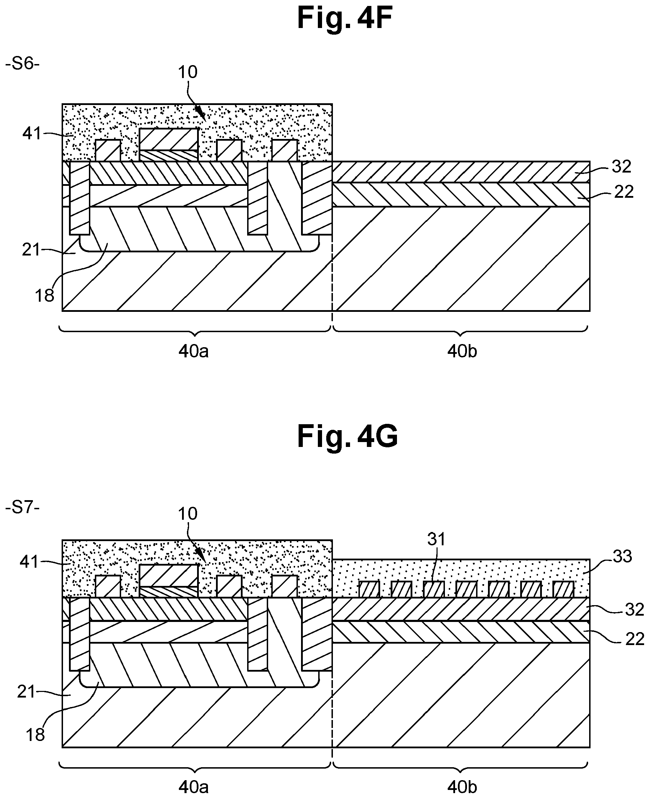

[Fig. 4F] : En référence à la figure 4F, le procédé de fabrication peut comprendre ensuite une étape S6 de formation d'une première couche diélectrique 32 sur la couche de confinement 22. La première couche diélectrique 32 peut être obtenue par un dépôt pleine plaque d'un matériau diélectrique (ex. SiO₂), photolithographie puis gravure du matériau diélectrique en excès.

[Fig. 4G] : Enfin, à l'étape S7 de la figure 4G, au moins un composant passif 31 est formé sur la première couche diélectrique 32. La formation du composant passif 31 peut notamment comprendre le dépôt et la structuration d'une couche de métal, pour former des lignes de transmission, des spires, des électrodes.... Le composant passif 31 est avantageusement recouvert d'une deuxième couche diélectrique. Il peut être ultérieurement connecté au transistor formé dans la couche active 24, grâce à un ou plusieurs niveaux d'interconnexion situés au-dessus de la deuxième couche diélectrique (procédé dit de fin de ligne ou « BEOL »).

Le masque 41 peut être retiré après l'étape S7 de formation du composant passif 31.

Le dispositif électronique hybride et son procédé de fabrication ne sont pas limités aux modes de réalisation décrits ci-dessus en relation avec les figures. De nombreuses variantes et modifications apparaîtront à l'homme du métier. Par exemple, selon une modification qui n'appartient pas au cadre de la présente invention, la couche de confinement et le composant passif peuvent être formés avant le transistor MOS.

## Revendications

1. Procédé de fabrication d'un dispositif électronique (30), comprenant les étapes suivantes :
- fournir (S1) une structure multicouche (40) comprenant un substrat (21) en un matériau semi-conducteur de haute résistivité, une couche active (24) et une couche électriquement isolante (23) disposée entre le substrat (21) et la couche active (24) ;
- former (S2) dans une première région (40a) de la structure multicouche (40) au moins un transistor MOS à grille arrière (10) ;
- graver (S3) la couche active (24) et la couche électriquement isolante (23) dans une deuxième région (40b) de la structure multicouche (40), distincte de la première région (40a) ;
- former (S4, S5) une couche de confinement des électrons (22) sur le substrat (21) dans la deuxième région (40b) de la structure multicouche (40) ; et
- former (S7) au moins un composant passif (31), tel qu'une inductance, sur la couche de confinement des électrons (22) ;
procédé dans lequel ledit au moins un transistor MOS à grille arrière (10) est formé dans la première région (40a) avant l'étape (S3) de gravure de la couche active (24) et de la couche électriquement isolante (23) et dans lequel la couche de confinement des électrons (22) est formée dans la deuxième région (40b) après l'étape (S3) de gravure de la couche active (24) et de la couche électriquement isolante (23).

2. Procédé selon la revendication 1, dans lequel la couche active (24) et la couche électriquement isolante (23) sont gravées dans la deuxième région (40b) au travers d'un masque (41) et dans lequel le masque est retiré après l'étape (S7) de formation dudit au moins un composant passif (31).

3. Procédé selon l'une des revendications 1 et 2, comprenant en outre une étape de dépôt (S6) d'une couche diélectrique (32) sur la couche de confinement des électrons (22) avant l'étape (S7) de formation dudit au moins un composant passif (31).

4. Procédé selon l'une quelconque des revendications 1 à 3, dans lequel la formation de la couche de confinement des électrons (22) comprend les opérations suivantes :
- déposer une couche de matériau semi-conducteur amorphe ;
- recristalliser le matériau semi-conducteur amorphe de façon à obtenir une couche de matériau semi-conducteur polycristallin.

5. Procédé selon la revendication 4, dans lequel la formation de la couche de confinement des électrons (22) comprend en outre, avant l'opération de recristallisation, une opération consistant à introduire des impuretés dans le matériau semi-conducteur amorphe.

6. Procédé selon l'une quelconque des revendications 1 à 3, dans lequel la formation de la couche de confinement des électrons (22) comprend le dépôt d'une couche de matériau semi-conducteur polycristallin (22').

7. Procédé selon l'une quelconque des revendications 4 à 6, dans lequel la formation de la couche de confinement des électrons (22) comprend en outre une opération d'oxydation de la couche de matériau semi-conducteur polycristallin.

## Patentansprüche

1. Verfahren zur Herstellung einer elektronischen Vorrichtung (30), das die folgenden Schritte umfasst:
- Bereitstellen (S1) einer mehrschichtigen Struktur (40), die ein Substrat (21) aus einem Halbleitermaterial mit hohem Widerstand, eine aktive Schicht (24) und eine elektrisch isolierende Schicht (23), die zwischen dem Substrat (21) und der aktiven Schicht (24) angeordnet ist, umfasst;
- Bilden (S2) in einem ersten Bereich (40a) der mehrschichtigen Struktur (40) mindestens eines Backgate-MOS-Transistors (10);
- Ätzen (S3) der aktiven Schicht (24) und der elektrisch isolierenden Schicht (23) in einem zweiten Bereich (40b) der mehrschichtigen Struktur (40), der sich von dem ersten Bereich (40a) unterscheidet;
- Bilden (S4, S5) einer Elektronen-Einschlussschicht (22) auf dem Substrat (21) in dem zweiten Bereich (40b) der mehrschichtigen Struktur (40); und
- Bilden (S7) mindestens einer passiven Komponente (31), wie z. B. einer Induktivität, auf der Elektronen-Einschlussschicht (22);
Verfahren, bei dem der mindestens eine Backgate-MOS-Transistor (10) in dem ersten Bereich (40a) vor dem Schritt (S3) des Ätzens der aktiven Schicht (24) und der elektrisch isolierenden Schicht (23) gebildet wird und bei dem die Elektronen-Einschlussschicht (22) in dem zweiten Bereich (40b) nach dem Schritt (S3) des Ätzens der aktiven Schicht (24) und der elektrisch isolierenden Schicht (23) gebildet wird.

2. Verfahren nach Anspruch 1, bei dem die aktive Schicht (24) und die elektrisch isolierende Schicht (23) in dem zweiten Bereich (40b) durch eine Maske (41) geätzt werden und bei dem die Maske nach dem Schritt (S7) des Bildens der mindestens einen passiven Komponente (31) entfernt wird.

3. Verfahren nach einem der Ansprüche 1 und 2, ferner umfassend einen Schritt des Aufbringens (S6) einer dielektrischen Schicht (32) auf der Elektronen-Einschlussschicht (22) vor dem Schritt (S7) des Bildens der mindestens einen passiven Komponente (31).

4. Verfahren nach einem der Ansprüche 1 bis 3, bei dem die Bildung der Elektronen-Einschlussschicht (22) die folgenden Schritte umfasst:
- Aufbringen einer Schicht aus amorphem Halbleitermaterial;
- Rekristallisation des amorphen Halbleitermaterials, um eine Schicht aus polykristallinem Halbleitermaterial zu erhalten.

5. Verfahren nach Anspruch 4, bei dem die Bildung der Elektronen-Einschlussschicht (22) vor dem Rekristallisationsvorgang zusätzlich einen Vorgang des Einbringens von Verunreinigungen in das amorphe Halbleitermaterial umfasst.

6. Verfahren nach einem der Ansprüche 1 bis 3, bei dem die Bildung der Elektronen-Einschlussschicht (22) das Aufbringen einer Schicht aus polykristallinem Halbleitermaterial (22') umfasst.

7. Verfahren nach einem der Ansprüche 4 bis 6, bei dem die Bildung der Elektronen-Einschlussschicht (22) zusätzlich einen Oxidationsvorgang der Schicht aus polykristallinem Halbleitermaterial umfasst.

## Claims

1. Method for manufacturing an electronic device (30), comprising the following steps of:
- providing (S1) a multilayer structure (40) comprising a substrate (21) of high-resistivity semiconductor material, an active layer (24) and an electrically insulating layer (23) disposed between the substrate (21) and the active layer (24);
- forming (S2) at least one back-gate MOS transistor (10) in a first region (40a) of the multilayer structure (40);
- etching (S3) the active layer (24) and the electrically insulating layer (23) in a second region (40b) of the multilayer structure (40), distinct from the first region (40a);
- forming (S4, S5) an electron confinement layer (22) on the substrate (21) in the second region (40b) of the multilayer structure (40); and
- forming (S7) at least one passive component (31), such as an inductor, on the electron confinement layer (22);
wherein said at least one back-gate MOS transistor (10) is formed in the first region (40a) before the step (S3) of etching the active layer (24) and the electrically insulating layer (23) and wherein the electron confinement layer (22) is formed in the second region (40b) after the step (S3) of etching the active layer (24) and the electrically insulating layer (23).

2. Method according to claim 1, wherein the active layer (24) and the electrically insulating layer (23) are etched in the second region (40b) through a mask (41) and wherein the mask is removed after the step (S7) of forming said at least one passive component (31).

3. Method according to one of claims 1 and 2, further comprising a step of depositing (S6) a dielectric layer (32) on the electron confinement layer (22) before the step (S7) of forming said at least one passive component (31).

4. Method according to any of claims 1 to 3, wherein forming the electron confinement layer (22) comprises the following operations:
- depositing a layer of amorphous semiconductor material;
- recrystallising the amorphous semiconductor material so as to obtain a layer of polycrystalline semiconductor material.

5. Method according to claim 4, wherein the formation of the electron confinement layer (22) further comprises, prior to the recrystallisation operation, an operation of introducing impurities into the amorphous semiconductor material.

6. Method according to any of claims 1 to 3, wherein forming the electron confinement layer (22) comprises depositing a layer of polycrystalline semiconductor material (22').

7. Method according to any one of claims 4 to 6, wherein forming the electron confinement layer (22) further comprises an operation of oxidising the polycrystalline semiconductor material layer.
